Europäisches Patentamt

European Patent Office

Office européen des brevets

(19)

(11) Veröffentlichungsnummer: **0 362 213 B1**

(12) # EUROPÄISCHE PATENTSCHRIFT

(45) Veröffentlichungstag der Patentschrift :
14.08.91 Patentblatt 91/33

(51) Int. Cl.⁵ : **B28B 11/08**, H01G 4/30,
G03F 7/00, // C04B41/91

(21) Anmeldenummer : 88903191.0

(22) Anmeldetag : 27.04.88

(86) Internationale Anmeldenummer :
PCT/DE88/00250

(87) Internationale Veröffentlichungsnummer :
WO 88/08360 03.11.88 Gazette 88/24

(54) VERFAHREN ZUR HERSTELLUNG EINER STRUKTURIERTEN KERAMIKFOLIE BZW. EINES AUS SOLCHEN FOLIEN AUFGEBAUTEN KERAMIKKÖRPERS.

(30) Priorität : 27.04.87 DE 3713987

(43) Veröffentlichungstag der Anmeldung :
11.04.90 Patentblatt 90/15

(45) Bekanntmachung des Hinweises auf die
Patenterteilung :
14.08.91 Patentblatt 91/33

(84) Benannte Vertragsstaaten :
CH DE FR GB IT LI NL SE

(56) Entgegenhaltungen :
FR-A- 919 911
FR-A- 2 455 499
US-A- 4 528 260

(73) Patentinhaber : Siemens Aktiengesellschaft
Wittelsbacherplatz 2
W-8000 München 2 (DE)

(72) Erfinder : BAST, Ulrich
Georgenstr. 111
W-8000 München 40 (DE)

**Beschreibung**

Die vorliegende Erfindung bezieht sich auf ein Verfahren zur Herstellung einer strukturierten Keramikfolie. Des weiteren bezieht sich die Erfindung auf die Herstellung eines aus derartigen Keramikfolien bestehenden Keramikkörpers. Die Strukturierung einer solchen Keramikfolie besteht in Vertiefungen bzw. Aussparungen, die auch durch die Folie hindurchgehende Löcher sein können. Dabei erfolgt die Herstellung der Vertiefungen, Aussparungen oder Löcher durch Bearbeitung der Folie im Zustand einer Grünfolie. Unter einer Grünfolie ist das im Herstellungsverfahren einer Keramikfolie auftretende Zwischenstadium zu verstehen, in dem das nachfolgend zu einer Keramik zu sinternde Schlicker-Material mit darin enthaltenem Bindemittel bzw. Bindersystem in die Form der noch nicht gesinterten Folie gebracht ist.

Ein bekanntes derartiges Verfahren ist, die durch Ausziehen des Schlickers zu einer Folie gewonnene, aus dem Schlicker-Material und dem Bindersystem bestehende Grünfolie durch Stanzen mit Löchern zu versehen und schließlich diese strukturierte Grünfolie zu sintern. Man erhält dadurch eine der Dicke der Grünfolie entsprechende dünne, mit diesen Löchern versehene Keramikfolie, die z.B. als Substratplatte Verwendung finden kann. Derartige Substratplatten, insbesondere aus Aluminiumoxid, werden insbesondere in der elektronischen Schaltungstechnik für den Aufbau von Hybridschaltungen verwendet.

Es ist bereits bekannt, mit innenliegenden bzw. inneren Hohlräumen versehene Keramikkörper herzustellen.

Die DE-OS 1439702 beschreibt ein Herstellungsverfahren, bei dem bereits vor dem Sintern des für einen Kondensator vorgesehenen Keramikkörpers Hohlräume im Keramikkörper vorhanden sind.

Die Entwicklung ist dahin fortgeschritten, die Körper derartiger Vielschichtkondensatoren in der Weise herzustellen, daß auf Grünfolien eine Struktur aus einer Mischung aus Ruß und Zirkondioxid-Körnern, die der Struktur der vorgegebenen Hohlräume entspricht, aufgebracht wird. Solche mit Strukturen versehene Grünfolien werden aufeinandergestapelt, zusammengepreßt und gesintert, wobei die aufgebrachte Struktur in die Folie eingepreßt wird. Während des Sinterns verbrennt der Ruß und es bleiben in den entstehenden Hohlräumen die Zirkonoxid-Körner übrig. Die zwischen den Zirkonoxidkörnern entstandenen Hohlräume werden mit flüssigem Metall, insbesondere Blei, gefüllt, so daß sich innere Elektroden bilden.

Aus piezoelektrischer Keramik bestehende, im gesinterten Zustand monolithische Körper mit jedoch nicht ausgefüllten inneren Hohlräumen finden als Ultraschallwandler für insbesondere medizinische Diagnose Verwendung. Die Hohlräume, die in dem Piezokeramikmaterial so zahlreich und so klein sind, daß sie wie Poren wirken, vermindern die akustische Impedanz dieses Materials und verbessern so die akustische Anpassung des Materials des Ultraschallwandlers an das Körpergewebe. Es ist auch schon vorgeschlagen worden, langgestreckte Hohlräume im Inneren des Keramikkörpers eines Ultraschallwandlers auszubilden. Diese Hohlräume sind so ausgebildet und angeordnet, daß sie die Ausbildung störender Moden von Querschwingungen verhindern oder wenigstens vermindern.

Hier in Frage kommende Keramikkörper sind in der Weise hergestellt worden, daß zunächst einzelne Grünfolien auf fotolithografischem Wege mit strukturierter Fotolackschicht bzw. mit aus Fotolack bestehenden Strukturen versehen worden sind und diese Folien dann zu einem Stapel gepreßt und gesintert worden sind. Der zusammengesinterte Stapel bildet einen monolithischen Keramikkörper, in dessen Innerem sich solche Hohlräume befinden, die den fotolithografischen Strukturen auf den ursprünglichen Grünfolien entsprechen. Während des Sintervorganges brennt der Fotolack aus und hinterläßt im Folienstapel entsprechende Hohlräume. Derartige Hohlräume können in einem Keramikkörper exakt plaziert angeordnet werden (und zum Beispiel mit Metall gefüllt als Elektroden dienen). Verteilt angeordnete, im Regelfall kleinere Hohlräume in einem derartigen aus Grünfolien zusammengesinterten Keramikkörper führen dazu, daß eine gezielt dimensionierte Porosität im Keramikkörper vorliegt. Es ist aber festgestellt worden, daß bei den während des Sinterns auftretenden hohen Temperaturen der auf die Grünfolien aufgebrachte Fotolack schrumpft und Schädigungen der Oberfläche der jeweiligen Keramikfolie erzeugt. Außerdem besteht während des Sinterns durch das Ausbrennen des Fotolacks die Gefahr, daß der zusammengepreßte Stapel den einzelnen Folien (aus denen er ursprünglich zusammengesetzt worden ist) entsprechend delaminiert, d.h. in einzelne Schichten zerfällt. Auch ist es nicht möglich, mit diesen früher angewendeten Verfahren solche Keramikkörper herzustellen, in denen sich Hohlräume befinden, die sich über mehrere Ebenen erstrecken.

Aufgabe der vorliegenden Erfindung ist es, ein technologisch besonders einfaches Verfahren anzugeben, mit dessen Hilfe derartige mit Vertiefungen, Aussparungen oder Löcher strukturierte (zunächst noch ungesinterte) Keramikfolien hergestellt werden können. Eine Weiterbildung der Aufgabe besteht darin, dieses Verfahren so zu nützen, daß mit definierten Hohlräumen versehene Keramikkörper in einfacher Weise hergestellt werden können.

Diese Aufgabe wird mit einem Verfahren gelöst, das die Merkmale des Patentanspruches 1 aufweist. Ausgestaltungen dieses Verfahrens gehen aus den Unteransprüchen hervor.

Das erfindungsgemäße Verfahren wird in der Weise durchgeführt, daß auf die eine Oberfläche eine nach üblichem Verfahren hergestellten (noch ungesinterten) Grünfolie eine Fotolack- oder Trockenresist-Schicht/Folie (im folgenden als Fotolack bezeichnet), z.B. aus dem Material Kalle, Ozatec R225 aufgebracht wird. Diese fotoempfindliche Schicht wird nach bekanntem Verfahren der Fotolithografie zu einer Maskenschicht strukturiert, die bis auf die Oberfläche der Grünfolie herabreichende Löcher, Aussparungen und dgl. an denjenigen Stellen besitzt, an denen die Grünfolie und die später hergestellte Keramikfolie Löcher bzw. Hohlräume aufweisen soll.

Nachdem die Oberfläche der Grünfolie somit mit einer solchen Maskenschicht mit darin enthaltenen Löchern und dgl. versehen ist, wird diese Grünfolie auf der mit dem Fotolack versehenen Seite mit einem dünnen Flüssigkeitsstrahl beaufschlagt, mit dem eine Erosion durchgeführt wird, die zur Erzeugung der später dann vorliegenden Vertiefungen führt.

Je nach Feinheit der verlangten Vertiefungen, Löcher und dgl. kann mit einem entsprechend feinen Flüssigkeitsstrahl gearbeitet. Ein typischer Durchmesser für einen solchen Strahl beträgt 0,6 mm. Das für den Strahl vorgesehene, d.h. darin enthaltene Lösungsmittel ist ein solches, das dahingehend wirksam ist, das Bindersystem bzw. einen Bestandteil des Bindersystems zunächst so zum Quellen zu bringen, daß das folgende erosive Abtragen von Material der Grünfolie ermöglicht wird. Dieses erosive Abtragen wird mit hohem Strahldruck durchgeführt. Es kann auch mit vergleichsweise großflächigem Strahl oder gleichzeitig mit mehreren bzw. vielen Strahlen gearbeitet werden.

An denjenigen Stellen, die vom Fotolack bedeckt geblieben sind, findet keine Erosion statt, so daß die Vertiefungen in der Grünfolie tatsächlich nur an den von Fotolack nicht abgedeckten Stellen erfolgt. Der hier verwendete Strahl und die Grünfolie werden vorteilhafterweise zueinander bewegt, so daß an allen Stellen mit Löchern, Aussparungen und dgl. im Fotolack das erosive Abtragen von Material der Grünfolie durchführt wird. Nach diesem Verfahren können die Vertiefungen so weit getrieben werden, daß auch Löcher in der Grünfolie entstehen, d.h. ein Durchbohren der Grünfolie erfolgt ist.

Das Lösungsmittel wird gemäß einem Merkmal der Erfindung so gewählt, daß der Binder der Keramikfolie, nicht jedoch das Fotolackmaterial selbst, angegriffen wird. Das oben erwähnte Fotolackmaterial Ozatec R225 und ein für die Grünfolie vorgesehenes Bindersystem auf der Basis des Acrylsäureesters sind eine vorteilhafte Kombination, zu der Toluol oder eine Mischung aus Toluol und Dekahydronaphtalin, z.B. im Verhältnis von 3 :2 sehr vorteilhaft zu verwenden sind.

Insbesondere wird als Fotolack ein Material verwendet, bei dem beispielsweise durch ein Nachbelichten oder ein Tempern bei hoher Temperatur zusätzlich höhere chemische Beständigkeit zu bewirken ist. Es kann auch ein zusätzlicher Metallfilm verwendet werden, der höhere Beständigkeit erreichen läßt.

Nach Durchführung der beschriebenen Erosionsbehandlung wird der auf der Grünfolie noch vorhandene Fotolack abgelöst. Zum Beispiel ist hierfür bei Positiv-Fotolack ein jetzt ganzflächiges Belichten und Entwickeln des Fotolacks geeignet. Damit ist das noch vorhandene Fotolackmaterial löslich gemacht und läßt sich leicht entfernen.

Nach den voranstehenden Verfahrensschritten mit Vertiefungen bzw. Löchern versehene Grünfolien werden nach erfolgtem Entfernen des Fotolackmaterials gestapelt und bei erhöhter Temperatur einem Preßdruck ausgesetzt. Während des nachfolgenden Brennprozesses sintert der aus den ursprünglichen Grünfolien bestehende Folienstapel zu einem monolithischen Keramikblock zusammen, der aber als Hohlräume die zuvor hergestellten Vertiefungen und Löcher der einzelnen Grünfolien enthält.

Ein solcher monolithischer Keramikkörper mit nach dem Verfahren hergestellten, in vorgegebener Weise verteilten Hohlräumen wird weiteren Bearbeitungsschritten unterworfen, z.B. erfolgt ein Metallisieren zur Herstellung von Elektroden, das notwendige Polarisieren, mit dem die piezoelektrischen Eigenschaften wirksam werden.

Dem Prinzip nach ist Materialbearbeitung mit einem Flüssigkeitsstrahl an sich bekannt. So werden z.B. Stahlplatten mit einem Wasserstrahl geschnitten. Beim Verfahren der vorliegenden Erfindung dagegen wird ein im Prinzip zweistufiger Prozeß durchgeführt, nämlich man bewirkt durch Auswahl der Zusammensetzung der Flüssigkeit in bezug auf das zu bearbeitende Material, nämlich dessen Binder, daß ein Quellen und damit eine entsprechende Festigkeitsverminderung des Materials der Grünfolie eintritt. Das so behandelte Material, das auf diese Weise eine vom ursprünglichen Material der Grünfolie unterschiedliche Eigenschaft erhalten hat, wird dann durch die Flüssigkeitsstrahl-Behandlung abgetrennt und weg-gespült.

Diese erfindungsgemäß angewendeten Maßnah-men haben gegenüber einem an sich bekannten Laserstrahl-Strukturieren (von z.B. Leiterplatten) ganz entscheidende Vorteile.

Das erfindungsgemäß angewendete Bearbeitungsverfahren erzeugt im bearbeiteten Material keine Erhitzung. Der Flüssigkeitsstrahl vermag dagegen darüber hinaus sogar zu kühlen. Es können große Flächen in kurzer Zeit strukturiert, insbesondere ganzflächig abgetragen werden. Das schon erwähnte Ausbleiben einer Erwärmung schließt jegliches Verziehen der gewünschten Formen aus. Der organische Binder wird bei Anwendung der Erfindung nicht gasförmig zersetzt, sondern in flüssiger Form ausgewaschen. Dies schließt aus, daß ansonsten durch Kondensation der Zersetzungsprodukte an kühleren Teilen (der Apparatur) auftretende Niederschläge ausbleiben. Losgelöstes Material wird durch das Auswaschen entfernt und kann leicht abgeschieden werden. Stäube können nicht auftreten, so daß auch die Beherrschung von entsprechenden Arbeitsvorschriften in einfacher Weise zu erreichen ist.

Obwohl die bei der Erfindung angewendeten Maßnahmen gerade für die Abtragung großer Mengen geeignet ist, sind sie auch vorteilhaft für feinste Strukturen. Insbesondere läßt sich mit diesen Maßnahmen die Tiefe der Strukturierung leicht (z.B. leichter als mit Laserstrahlung) zuverlässig einstellen.

Diese bei der Erfindung angewendeten Maßnahmen durchzuführen erfordert, z.B. gegenüber Laserstrahl-Materialbearbeitung, keine aufwendigen und erst recht auch keine großen Raumbedarf bedingende Apparaturen.

In der obengenannten DE-OS 2142535 ist z.B. angegeben, mit der bearbeitenden Laserstrahlung Bleioxide und Titanoxide leicht in metallisches Blei und Titan konvertieren zu können. Bei den auftretenden Temperaturen liegt dieses Blei zu einem Anteil in Dampfform vor.

Nachfolgend werden anhand von Figuren Beispiele für nach dem erfindungsgemäßen Verfahren hergestellte monolithische Keramikkörper beschrieben.

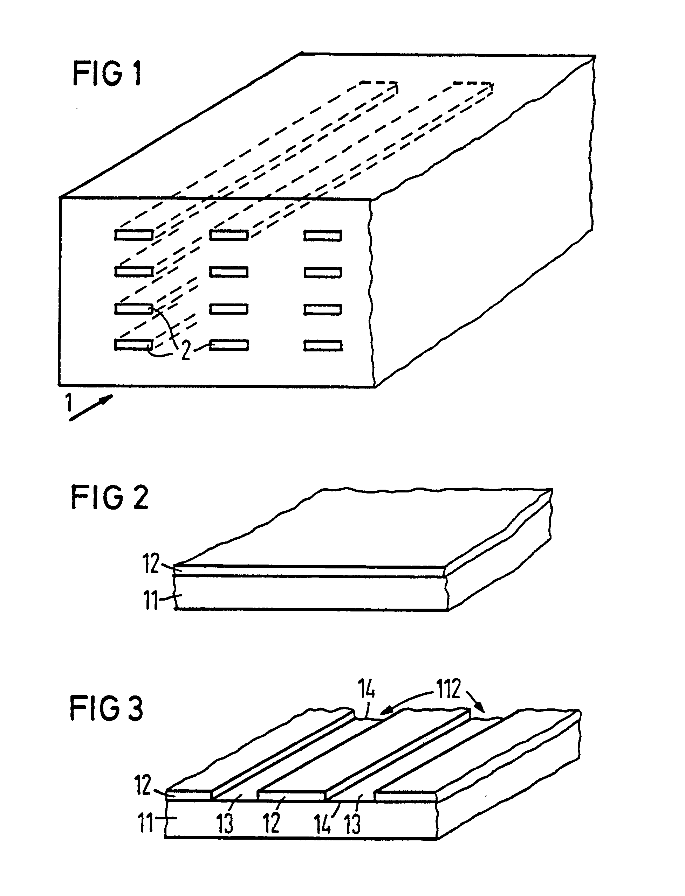

Die Figur 1 zeigt einen nach der Erfindung hergestellten monolithischen, gesinterten Keramikkörper 1, der mit 2 bezeichnete kanalartige Hohlräume aufweist, die in Ausführung und Lage wie aus der Figur 1 ersichtlich gestaltet und positioniert sind.

Gemäß einem Beispiel der Erfindung wird ein solcher monolithischer Keramikkörper 1 in der Weise hergestellt, daß eine Vielzahl Grünfolien hergestellt werden, wie das Beispiel der Figur 2 zeigt. Die Grünfolien können aus Zusammensetzungen für gesinterte Piezokeramik, Substratkeramik und dgl, z.B. aus Bleizirkonat-Titanat, Aluminiumoxid usw. bestehen.

Die Grünfolie 11 ist in Figur 2 bereits mit einer Schicht 12 aus Fotolackmaterial ganzflächig beschichtet.

Auf üblichem fotolithografischem Wege wird diese Fotolackschicht 12 mit der in Figur 3 dargestellten Struktur 112 versehen. In einzelnen Streifen 13 ist das Material der Fotolackschicht 12 so weit beseitigt, daß die ursprüngliche Oberfläche 14 der Grünfolie 11 freiliegt. Die Strukturen 112 haben Abmessungen bis herab z.B. 50 µm entsprechend den im wesentlichen gleichgroßen Abmessungen der herzustellenden Vertiefungen, Hohlräume, Löcher und dgl. in der Grünfolie bzw. dem fertigen Körper.

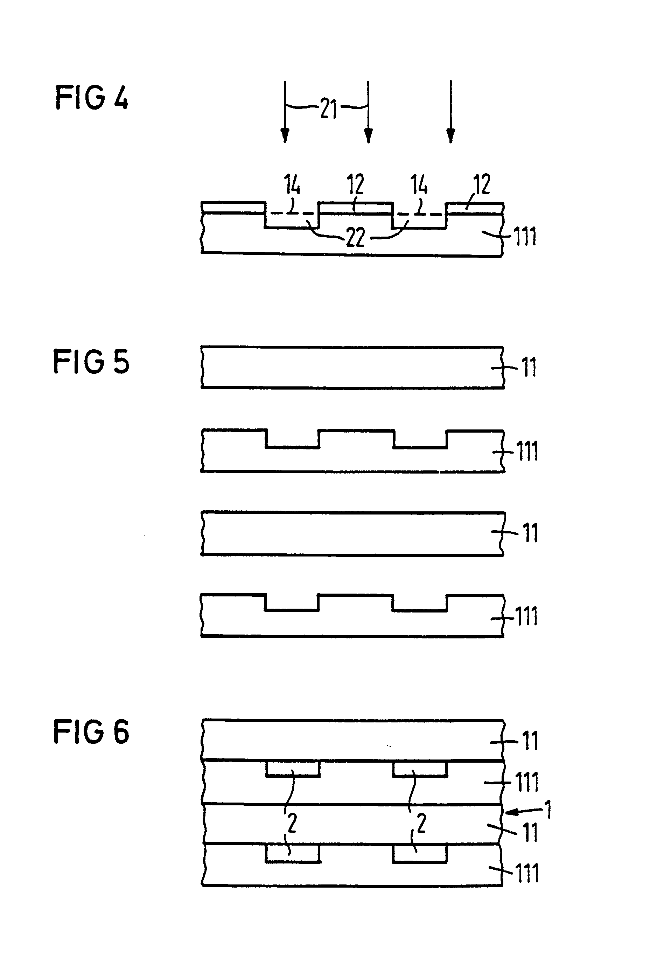

Figur 4 zeigt die Beaufschlagung der Grünfolie 11, mit einem Flüssigkeitsstrahl 21, und zwar von der mit Fotolackschicht 12 versehenen Seite her.

Die Erosionswirkung des Flüssigkeitsstrahls 21 bewirkt eine streifenförmige Vertiefung 22 in der Oberfläche der nunmehr strukturierten Grünfolie 111, wie dies in Figur 4 gezeigt ist.

Figur 5 zeigt in auseinandergezogener Darstellung zwei Grünfolien 111, die nach dem erfindungsgemäßen Verfahren bearbeitet worden sind und zwei unveränderte Grünfolien 11. In der aus dieser Figur hervorgehenden Weise sind z.B. solche Folien 111, 11, 111, 11.... aufeinandergestapelt. Ein solcher zusammengepreßter Stapel wird in an sich üblicher Weise gesintert, so daß daraus ein monolithischer Keramikkörper 1 mit den darin enthaltenen Kanälen 2 entsteht (Fig. 6).

**Patentansprüche**

1. Verfahren zur Herstellung einer Keramikfolie mit Vertiefungen, Löchern, Aussparungen und dgl., wobei diese Strukturierung der Folie in deren Zustand als Grünfolie mit darin enthaltenem Bindersystem mit Hilfe der Fotolithografie erfolgt, **gekennzeichnet dadurch,**
daß eine Oberfläche der Grünfolie mit einer solchen Fotolackschicht versehen wird,
in die zur Verwendung als Maske auf fotolithografischem Wege die Strukturen mit der vorgegebenen flächenhaften Verteilung und Größe der zu erzeugenden Vertiefungen, Löcher, Aussparungen und dergl. hergestellt werden, daß diese Vertiefungen, Löcher, Aussparungen und dergl. durch Erosion mittels eines Flüssigkeitsstrahls bis zu jeweils vorgegebener Tiefe in der Grünfolie hergestellt werden, wobei die strukturierte Fotolackschicht als Maskenschicht für die jeweilige Erosion wirksam ist und
daß für den Flüssigkeitsstrahl ein Mittel verwendet wird, das ein selektives Lösungsvermögen für das im Material der Grünfolie enthaltene Bindersystem besitzt.

2. Verfahren nach Anspruch 1, **gekennzeichnet dadurch,** daß für ein Bindersystem auf der Basis von Acrylsäureester das Medium des Flüssigkeitsstrahls im wesentlichen Benzol-Kohlenwasserstoff ist und ein solches Material für die Fotolackschicht verwendet ist, das gegenüber dem Benzol-Kohlenwasserstoff für wenigstens den Zeitraum der Bearbeitung beständig ist.

3. Verfahren zur Herstellung gesinterter Körper (1) mit innenliegenden Hohlräumen (2), **gekennzeichnet dadurch,** daß eine Anzahl nach einem Verfahren wenigstens eines der Ansprüche 1 bis 3 mit Vertiefungen, Löchern, Aussparungen und dgl. hergestellte Grünfolien (11) aufeinandergestapelt (Fig. 6), gepreßt und anschließend gesintert werden.

4. Verfahren nach Anspruch 3, **gekennzeichnet dadurch,** daß sowohl nach einem der Ansprüche 1 bis 3 hergestellte Grünfolien (11) als auch nichtstrukturierte Grünfolien (11) aufeinandergestapelt, gepreßt und anschließend gesintert werden (Fig. 6).

5. Verwendung eines nach einem der Ansprüche 3 oder 4 hergestellten monolithischen Körpers aus Piezokeramik für Ultraschallwandler.

## Claims

1. Process for manufacturing a structured ceramic film with depressions, holes, clearances and the like, this structuring of the film being performed in its state as a green film, with binder system contained therein, with the aid of photolithography, characterised in that

one surface of the green film is provided with such a photoresist layer, in which the structures having the predetermined surface distribution and size of the depressions, holes, clearances and the like to be created are produced by photolithographic means for use as a mask, in that

these depressions, holes, clearances and the like are produced in the green film by erosion by means of a liquid jet down to a respective predetermined depth, the structured photoresist layer being effective as a mask layer for the respective erosion and in that,

for the liquid jet, a medium is used which has a selective solvent power for the binder system contained in the material of the green film.

2. Process according to Claim 1, characterised in that, for an acrylate-based binder system, the medium of the liquid jet is substantially benzene hydrocarbon and, for the photoresist layer, a material is used which is resistant to benzene hydrocarbon for at least the time required for working.

3. Process for manufacturing sintered objects (1) with internal cavities (2), characterised in that a number of green films (11) manufactured by a process of at least one of Claims 1 to 3 with depressions, holes, clearances and the like are stacked one on top of the other (Fig 6), pressed and subsequently sintered.

4. Process according to Claim 3, characterised in that both green films (11) manufactured according to one of Claims 1 to 3 and non-structured green films (11) are stacked one on top of the other, pressed and subsequently sintered (6).

5. Use of a monolithic object of piezoceramic manufactured according to one of Claims 3 or 4 for ultrasonic transducers.

## Revendications

1. Procédé pour fabriquer une feuille céramique comportant des renfoncements, des trous, des évidements et analogues, cette structuration de la feuille s'effectuant dans son état de feuille à vert, avec un système formant liant contenu dans cette feuille, au moyen de la photolithographie, caractérisé par le fait qu'on dépose, sur une surface de la feuille à vert, une couche de laque photosensible,

dans laquelle, pour son utilisation en tant que masque, on forme par voie photolithographique les structures avec la répartition et la taille, prédéterminées du point de vue surface, des renfoncements, trous, évidements et analogues, devant être formés,

qu'on fabrique ces renfoncements, trous, évidements et analogues par érosion au moyen d'un jet de liquide jusqu'à une profondeur respectivement prédéterminée dans la feuille à vert, la couche de laque photosensible structurée agissant en tant que couche de masque pour la corrosion respective, et que, pour le jet de liquide, on utilise une substance qui possède un pouvoir sélectif de dissolution pour le système formant liant contenu dans le matériau de la feuille à vert.

2. Procédé suivant la revendication 1, caractérisé par le fait que, pour un système formant liant réalisé à base de l'ester de l'acide acrylique, la substance constituant le jet liquide est essentiellement un hydrocarbure de benzène et qu'on utilise pour la couche de laque photosensible une substance qui résiste à l'hydrocarbure de benzène au moins pendant l'intervalle de temps du traitement.

3. Procédé pour fabriquer des corps frittés (1) possédant des cavités internes (2), caractérisé par le fait qu'on empile (figure 6), on comprime et ensuite on fritte un certain nombre de feuilles à vert (11) fabriquées selon un procédé correspondant à au moins l'une des revendications 1 à 3, avec des renfoncements, des trous, des évidements et analogues.

4. Procédé suivant la revendication 3, caractérisé par le fait qu'on empile, on presse et ensuite on fritte (figure 6) aussi bien des feuilles à vert (11) fabriquées selon l'une des revendications 1 à 3 que des feuilles à vert (11) non structurées.

5. Utilisation d'un corps monolithique formé d'une piézocéramique et fabriqué selon l'une des revendications 3 ou 4, pour des transducteurs à ultrasons.

FIG 1

1

2

FIG 2

12

11

FIG 3

14 112

12

11 13 12 14 13

FIG 4

FIG 5

FIG 6